# EUROPÄISCHE PATENTSCHRIFT

(11) **EP 1 891 673 B1**
(45) Veröffentlichungstag und Bekanntmachung des Hinweises auf die Patenterteilung: **05.12.2018**
(21) Anmeldenummer: 06743036.3
(22) Anmeldetag: 23.05.2006
(51) Int. Cl.: H01L 27/146, H01L 31/0224

(54) **PHOTODIODE MIT INTEGRIERTER HALBLEITERSCHALTUNG UND VERFAHREN ZUR HERSTELLUNG**
PHOTODIODE WITH INTEGRATED SEMICONDUCTOR CIRCUIT AND METHOD FOR THE PRODUCTION THEREOF
PHOTODIODE DOTE D'UN CIRCUIT A SEMI-CONDUCTEURS INTEGRE ET SON PROCEDE DE PRODUCTION

(30) Priorität: 07.06.2005 DE 102005026242
(43) Veröffentlichungstag der Anmeldung: 27.02.2008
(73) Patentinhaber: ams AG, 8141 Premstätten (AT)
(72) Erfinder: MEINHARDT, Gerald, 8010 Graz (AT); SCHRANK, Franz, 8052 Graz (AT); VESCOLI, Verena, 8010 Graz (AT)
(74) Vertreter: Epping - Hermann - Fischer
(86) Internationale Anmeldenummer: PCT/EP2006/004903
(87) Internationale Veröffentlichungsnummer: WO 2006/131209

(56) Entgegenhaltungen:
- US-A- 6 114 685
- US-A1- 2004 013 338
- US-A1- 2005 035 381
- US-B1- 6 809 008

## Beschreibung

Es sind SOI Schichten (silicon on isolator) bekannt, bei denen eine monokristalline Halbleiter-Schicht (SOI Schicht) über einer dielektrischen Schicht angeordnet ist. Die dielektrische Schicht ist üblicherweise die Deckschicht eines Trägersubstrats. In solchen Substraten können CMOS Schaltungen oder auch MEMS Bauelemente (micro electro mechanical system) realisiert werden.

Es ist bekannt, Halbleiter Bauelemente in SOI Schichten durch Strukturierung der Oberfläche und insbesondere durch Herstellung dotierter Gebiete in der Oberfläche zu realisieren.

Dioden und insbesondere Photodioden sind Halbleiter Bauelemente, die eine relativ hohe Schichtdicke für den Halbleiter erfordern, damit die Raumladungszone innerhalb des Halbleiters ungestört ist. Es ist bekannt, Photodioden in Arrays anzuordnen, um damit beispielsweise Bilderkennungen durchzuführen. Die elektrischen Zuleitungen zur Ansteuerung der Einzeldioden im Array werden dabei in der Regel auf der Oberfläche des Halbleiters angeordnet. Weiterhin sind hier zusätzliche integrierte Halbleiterschaltungen erforderlich, um die vom Photodioden Array gelieferten Signale zu verarbeiten und gegebenenfalls auszuwerten. Die Halbleiterschaltungen können dabei im selben Substrat neben dem Array erzeugt werden und müssen über eine Verschaltung mit den einzelnen Dioden des Arrays verbunden werden. Ab einer bestimmten Arraygröße steigt der Verschaltungsaufwand dabei so stark an, dass er nicht mehr lohnend durchgeführt werden kann.

Möglich ist es auch, die integrierten Halbleiterschaltungen auf einem getrennten Substrat zu realisieren und extern mit dem Photodioden Array zu verbinden. Auch hier entsteht ein erheblicher Verschaltungsaufwand. Darüber hinaus wird sowohl bei getrennten Bauelementen als auch bei auf einem Substrat integrierten Ausführungen die erreichbare Dichte an Einzeldioden auf der zur Verfügung stehenden Halbleiteroberfläche begrenzt. Getrennt realisierte Bauelemente erfordern außerdem einen höheren Aufwand für das Packaging .

In US 6,809,008 B1 ist ein integrierter Fotosensor für Bauelemente zur Bilderfassung beschrieben, bei dem eine Siliziumepitaxieschicht, die eine Fotodiode enthält, an der von der Lichteinfallseite abgewandten Rückseite über eine SiO₂-Schicht mit einem CMOS-Wafer verbunden ist. Durchkontaktierungen durch die Siliziumepitaxieschicht sind mit metallischen Anschlussflächen der Fotodiode, die in der SiO₂-Schicht eingebettet sind, verbunden. Dort können auch noch weitere Metallflächen angeordnet sein, die als optische Reflektoren vorgesehen sind.

Aufgabe der Erfindung ist es daher, eine Photodiode und eine Halbleiterschaltung in einem Bauelement zu integrierten, welches die genannten Nachteile vermeidet.

Diese Aufgabe wird erfindungsgemäß durch ein Bauelement mit den Merkmalen von Anspruch 1 gelöst. Vorteilhafte Ausgestaltungen der Erfindung sowie ein Verfahren zur Herstellung des Bauelements sind weiteren Ansprüchen zu entnehmen.

Die Erfindung schlägt vor, einen Halbleiterkörper mit darin ausgebildeter Halbleiterschaltung und eine in einem Schichtaufbau realisierte Fotodiode in einem Bauelement zu kombinieren, indem die Fotodiode an der Rückseite des Halbleiterkörpers, die der Halbleiterschaltung gegenüber liegt, angeordnet ist. Halbleiterschaltung und Schichtaufbau mit Fotodiode sind dabei getrennt voneinander erzeugt und werden erst in einem späteren Schritt, vorzugsweise durch Waferbonden, unter Dazwischenanordnung einer Trennschicht fest miteinander verbunden.

Auf diese Weise wird ein monolithisches oder quasi monolithisches Bauelement erhalten. Die elektrische Verbindung der Halbleiterschaltung mit der Fotodiode erfolgt über Durchkontaktierungen, die von der Oberseite des Halbleiterkörpers bis zum Schichtaufbau geführt sind.

Das vorgeschlagene Bauelement ist kompakt und kann die gesamte Rückseite für den Aufbau der Diode nutzen. Die Rückseite des Schichtaufbaus steht als Lichteinfallsfläche zur Verfügung.

Die Fotodiode ist vorzugsweise auf einem SOI-Substrat aufgebaut, welches entweder direkt durch einen SOI-Prozess erzeugte Teilschichten für den Schichtaufbau aufweist oder bei dem weitere Teilschichten für den Schichtaufbau mittels CVD, vorzugsweise in einem epitaktischen Verfahren auf dem SOI-Substrat abgeschieden sind.

Der kristalline Halbleiterkörper für die Halbleiterschaltung ist in herkömmlicher Weise ausgebildet, ebenso die Halbleiterschaltung, die in seiner Oberseite (der Rückseite gegenüberliegend) verwirklicht und beispielsweise mit CMOS-Technik ausgeführt ist. Möglich ist es jedoch auch, dass die Halbleiterschaltung bipolare oder hetero-bipolare Schaltungselemente umfasst. Entsprechend kann der kristalline Halbleiterkörper auch mehrere Schichten gegebenenfalls unterschiedlichen Halbleitermaterials umfassen, sofern dies die entsprechende Technologie für den Aufbau der Halbleiterschaltung erfordert.

Die Halbleiterschaltung ist ausgelegt zum Ansteuern der Fotodiode, zum Verarbeiten der von der Fotodiode gelieferten Signale und gegebenenfalls auch zum Auswerten dieser Signale.

Die Fotodiode ist in einem Schichtaufbau verwirklicht, der zumindest eine n⁺-dotierte Teilschicht als unterste Schicht, eine n-dotierte Teilschicht darüber und weiterhin zumindest eine p-dotierte Teilschicht und/oder eine p⁺-dotierte Anschlussdotierung aufweisen kann, wobei sich zwischen den p- und n-dotierten Teilschichten ein Halbleiterübergang ausbildet. Als untere Schicht wird die Schicht oder Teilschicht verstanden, die am weitesten von der Halbleiterschaltung entfernt ist.

Oder anders ausgedrückt ist das Bauelement bei dieser und allen folgenden Betrachtungen so ausgerichtet, dass die Oberfläche mit der Halbleiterschaltung nach oben weist.

Es sind zumindest zwei Durchkontaktierungen vorgesehen, die die beiden Anschlüsse der Fotodiode mit den entsprechenden Anschlüssen der Halbleiterschaltung verbinden. Die Durchkontaktierungen sind als durch den Halbleiterkörper geätzte Löcher ausgebildet, die durch die Trennschicht, die üblicherweise eine isolierende Schicht ist, hindurch bis zur obersten Teilschicht des Schichtaufbaus geführt sind. Eine Metallisierung, mit der die Durchkontaktierungen innen ausgekleidet sind, oder elektrisch leitend eingestelltes Polysilizium macht die Durchkontaktierungen elektrisch leitend.

Ein geeigneter Schichtaufbau umfasst beispielsweise eine relativ dicke n-dotierte Teilschicht, die einen Großteil der für den Schichtaufbau erforderlichen Schichtdicke bereitstellt. In dieser n-dotierten Teilschicht ist für den Anodenkontakt eine relativ dünne p⁺ -dotierte obere Kontaktdotierung ausgeführt. Der Rückseiten- oder Kathodenkontakt wird ebenfalls in einem oberen Bereich der n-dotierten Teilschicht als n⁺ -dotierte Rückseiten-Kontaktdotierung neben der genannten oberen Kontaktdotierung ausgeführt. Diese Ausgestaltung ist besonders einfach herzustellen, da zum Anschluss des Rückseitenkontakts keine aufwändigen Durchführungen durch den Schichtaufbau erforderlich sind und beide Anschlüsse auf der Oberseite der obersten Teilschicht als dünne Dotierungen erzeugt werden können.

In einer alternativen Ausführung wird der Rückseitenkontakt über ein n-dotiertes Rückseiten-Anschlussgebiet vorgenommen, welches von der untersten n⁺ -dotierten Teilschicht durch alle darüber liegenden Teilschichten des Schichtaufbaus geführt ist und in dessen obersten Bereich eine relativ dünne n⁺-dotierte Rückseiten-Anschlussdotierung für den Kathodenkontakt erzeugt ist.

Beide Anschlüsse der Fotodiode werden vorzugsweise über hochdotierte Kontaktdotierungen vorgenommen, die im Schichtaufbau oben angeordnet sind. Die entsprechenden Durchkontaktierungen enden dann direkt über den Kontaktdotierungen, wobei in diesen Bereichen die Trennschicht eine Ausnehmung aufweist.

Vorzugsweise erstreckt sich das Rückseiten-Anschlussgebiet, welches eine elektrische Verbindung von der untersten Teilschicht der Fotodiode hin zum entsprechenden Rückseiten-Anschlusskontakt bildet, entlang dem äußeren Rand der Diode und begrenzt diese zumindest an einer Außenkante. Das Rückseiten-Anschlussgebiet kann gegen den übrigen Schichtaufbau mit einer Grabenisolierung isoliert sein, also einem mit Isoliermaterial gefülltem Graben. Das Rückseiten-Anschlussgebiet kann auch die gesamte Diodenfläche ringförmig umschließen und so gleichzeitig eine das Bauelement allseitig begrenzende Isolierung der Diode darstellen.

Vorzugsweise umfasst das Bauelement eine Vielzahl von regelmäßig im Schichtaufbau nebeneinander angeordneten Dioden, denen jeder zumindest eine Halbleiterschaltung zugeordnet ist, die direkt darüber im Halbleiterkörper angeordnet ist. Diese Vielzahl von Dioden bildet dabei ein Dioden-Array, welches über entsprechend miteinander verbundene Halbleiterschaltungen zu einem einzigen elektrischen Bauelement verbunden ist.

Im Dioden-Array können die einzelnen Dioden durch mit einem isolierenden Material gefüllte Gräben gegeneinander isoliert sein. Dazu können die das Rückseiten-Anschlussgebiet begrenzenden Gräben genutzt werden. Es können jedoch auch zusätzliche mit Isoliermaterial gefüllte Gräben vorgesehen sein.

Die Strukturierung des Dioden-Arrays, die insbesondere durch die elektrisch isolierenden trennenden Gräben erfolgt, kann in einem beliebigen Muster vorgenommen sein. In einer technisch einfachen Ausführung weist jede Diode eine rechteckige Grundfläche auf, die im Array zu einem schachbrettartigen Muster kombiniert werden können. Möglich ist es jedoch auch, einzelne Dioden in Reihen nebeneinander anzuordnen, wobei jeweils zwei benachbarte Reihen gegeneinander versetzt sind. Dabei ist es auch möglich, von der rechteckigen Grundfläche der Diode abzuweichen und beispielsweise eine sechseckige oder anders geformte Grundfläche vorzusehen.

Die Fotodiode ist vorzugsweise in einem Schichtaufbau realisiert, der aus Siliziumteilschichten aufgebaut ist. Die Fotodiode kann eine PN-Struktur oder eine PIN-Struktur aufweisen. Vorzugsweise ist die unterste Schicht n- oder n⁺ -dotiert.

Eine als Fotodiode genutzte Diode weist vorzugsweise eine Schichtdicke auf, die der Eindringtiefe des nachzuweisenden Lichts entspricht. Langwelliges sichtbares Licht hat in kristallinem Silizium eine Eindringtiefe von einigen 10 *µ*m. Möglich ist es jedoch auch, mit einer Fotodiode nahes infrarotes Licht nachzuweisen, welches eine noch höhere Eindringtiefe aufweist. Für eine Fotodiode mit hoher Rotempfindlichkeit besitzt der Schichtaufbau daher eine Schichtdicke von beispielsweise ca. 10 bis 20 *µ*m. Für andere Anwendungen der Fotodiode zum ausschließlichen Nachweis von kurzwelligerem Licht kann die Fotodiode auch entsprechend dünner ausgebildet sein. Dabei ist es vorteilhaft, die sich am PN-Übergang ausbildende Raumladungszone zur Absorption der Strahlung zu nutzen und diese so dick auszuführen, dass darin ein möglichst hoher Anteil des einfallenden und nachzuweisenden Lichts absorbiert wird. Nur dann gelingt ein schneller Nachweis der Strahlung, da die Ladungsträgerpaare nur im Feld der Raumladungszone beschleunigt werden, außerhalb aber nur durch langsamere Driftbewegung zu den Elektrodenkontakten gelangen können.

Zur Herstellung des Bauelements wird die Halbleiterschaltung im kristallinen Halbleiterkörper separat erzeugt. Auf einem davon getrennten Substrat werden der Schichtaufbau und die Anschlüsse für die Fotodiode erzeugt, insbesondere auf einem SOI-Substrat.

Vor dem Verbinden von Halbleiterkörper und Schichtaufbau wird auf einer der dazu vorgesehenen Oberflächen eine insbesondere dielektrische Trennschicht erzeugt, beispielsweise eine Oxidschicht. Anschließend können die beiden zu verbindenden Oberflächen in einem separaten Prozess glatt geschliffen und für die Verbindung aktiviert werden, beispielsweise durch Plasmabehandlung. Anschließend wird ein Wafer-Bond-Verfahren durchgeführt, insbesondere in einem Standardniedertemperaturprozess durch Backen bei Temperaturen unterhalb von 400 °C. Diese Verfahren sind CMOS-kompatibel und können daher ohne schädlichen Einfluss sowohl für die Diode als auch für die Halbleiterschaltung durchgeführt werden.

Bei der Diodenherstellung kann von einem SOI-Substrat ausgegangen werden, bei dem ein Hilfsträger, beispielsweise ebenfalls ein Siliziumwafer, mit einer Oxidschicht versehen wird, auf den dann ein zweiter, zumindest eine funktionelle Schicht tragender Halbleiterwafer durch Waferbonden aufgebracht und anschließend wieder gedünnt wird. Weist der zweite Wafer bereits auf seiner Oberfläche eine Schichtstruktur auf, so gelingt es mit dem Waferbond-Verfahren ein SOI-Substrat mit eben dieser Schichtstruktur herzustellen, die dann jedoch in umgekehrter Reihenfolge auf dem Hilfsträger aufsitzt. Vorzugsweise weist das SOI-Substrat daher bereits als unterste Teilschicht über dem Isolator eine n⁺ -dotierte Teilschicht und darüber eine n-dotierte oder intrinsische Teilschicht auf. In hintereinanderfolgenden Prozessen können anschließend weitere Teilschichten durch Epitaxie darüber abgeschieden werden, beispielsweise eine p-dotierte Schicht.

In allen Ausführungen ist es sinnvoll, den Halbleiterübergang in der Nähe der Oberseite oder der Unterseite des Schichtaufbaus zu erzeugen. Dementsprechend erfolgt der Übergang von einer n-Dotierung auf eine p-Dotierung im Schichtaufbau entweder nahe der Rückseite oder nahe der Oberseite. Im letztgenannten Fall ist es möglich, keine durchgehende p-dotierte Teilschicht abzuscheiden, sondern nur eine p⁺-dotierte Anschlusskontaktdotierung in einer n-dotierten Teilschicht zu erzeugen.

Für den Fall eines in der Nähe der Rückseite liegenden PN-Übergangs ist es vorteilhaft, über der untersten n-dotierten Teilschicht jeweils eine p-dotierte Teilschicht zu erzeugen, direkt danach in dieser Teilschicht im Bereich des späteren Rückseiten-Anschlussgebiets eine n-doteierte Rückseiten-Anschlussdotierung zu erzeugen und die Prozesse Schichtabscheidung und Dotierung im Rückseiten-Anschlussgebiet mehrfach zu wiederholen, bis eine gewünschte Gesamtschichtdicke erreicht ist. Dies hat den einen Vorteil, dass trotz geringem thermischen Budget dennoch eine homogene Dotierung erzeugt werden kann. Darüber hinaus ergibt sich durch die Mehrzahl der Teilschichten mit jeweils darin ausgeführter Rückseiten-Anschlussdotierung eine über die gesamte Höhe des Schichtaufbaus gleichmäßige Verteilung dieser Dotierung, die bei entsprechend großen Schichtdicken des Schichtaufbaus durch eine einzige Dotierung von der Oberseite her so nicht erhalten werden kann. In einem später durchgeführten Temperprozess kann eine weitere Homogenisierung der Dotierung im Rückseiten-Anschlussgebiet erhalten werden.

Das Rückseiten-Anschlussgebiet kann ringförmig so ausgeführt werden, dass es die Grundfläche der Diode umschließt. Es kann dann nach innen zur aktiven Diodenfläche hin von einem Isoliergraben begrenzt sein. Möglich ist es auch, das Rückseiten-Anschlussgebiet beiderseits mit einem Isoliergraben zu begrenzen und so gegenüber dem restlichen Schichtaufbau und der gegebenenfalls benachbarten Fotodiode im Diodenarray zu isolieren.

In der obersten Teilschicht des Schichtaufbaus kann abschließend noch eine den Anschlusswiderstand verringernde p⁺ Kontakt-Dotierung erzeugt werden.

Der Schichtaufbau ist bei der Durchführung des Waferbond-Verfahrens und darüber hinaus fest mit dem Hilfsträger verbunden und so mechanisch stabilisiert. Durch das Waferbonden gewinnen sowohl Halbleiterkörper als auch SOI-Substrat mit Schichtaufbau an zusätzlicher Schichtdicke und somit zusätzlicher Stabilität, sodass der Halbleiterkörper vor dem Waferbonden von seiner Rückseite her gedünnt werden kann. Dabei wird die Dicke des Halbleiterkörpers so weit reduziert, dass der Halbleiterkörper beim Waferbondprozess eben noch ohne die Gefahr eines Waferbruchs mit dem Schichtaufbau verbunden werden kann.

Erst nach Durchführung sämtlicher Strukturierungsschritte wird der Hilfsträger bis auf seine Isolatorschicht entfernt, beispielsweise durch ein kombiniertes Schleif- und Ätzverfahren. Vorzugsweise wird der Hilfsträger bis dicht über die Isolatorschicht des SOI-Substrats abgeschliffen und der verbleibende Rest mit einem Ätzverfahren entfernt. Möglich ist es auch, das Ätzverfahren für den gesamten Prozess einzusetzen, beispielsweise ein Spinätzen. Dies hat den Vorteil, dass es nur die behandelte Rückseite des Bauelements ätzt und die Oberseite mit der Halbleiterschaltung nicht extra gegen den Ätzangriff geschützt werden muss. Dabei ist es möglich, die Isolatorschicht an der späteren Rückseite des Bauelements, also an der Lichteinfallsfläche unversehrt zu erhalten. Dies ist für die optischen Eigenschaften der Oberfläche von Vorteil.

Zusätzlich können anschließend noch weitere Passivierungsschichten und insbesondere eine Anti-Reflex-Beschichtung aufgebracht werden, die eine oder mehrere Schichten mit einer optischen Schichtdicke von jeweils ca. einem Viertel der Wellenlänge umfasst. Durch unterschiedliche Schichten gelingt eine Anpassung der Anti-Reflexschicht auf verschiedene Wellenlängen, deren Reflexion auf diese Weise vermindert wird.

Die Halbleiterschaltung im Halbleiterkörper wird so weit vor dem Waferbonden fertiggestellt, dass die letzte Isolatorschicht vor dem Aufbringen der Kontakte aufgebracht ist. In einer Verfahrensvariante können vor dem Waferbonden auch noch die Kontaktlöcher für die Durchkontaktierungen geätzt werden. Dabei ist es möglich, die Kontaktlöcher im Halbleiterkörper bis knapp unter die Rückseite des Halbleiterkörpers zu führen. Im anschließenden Dünnungsprozess werden dann die Öffnungen der Kontaktlöcher von der Rückseite her freigelegt.

Im anderen Fall werden die Kontaktlöcher nach dem Waferbonden erzeugt, beispielsweise in einem DRIE-Prozess, der mit Hilfe einer Ätzmaske durchgeführt werden kann. Die Trennschicht zwischen Halbleiterkörper und Schichtaufbau kann dabei als Ätzstoppschicht dienen und ist dann beispielsweise aus Siliziumoxid ausgeführt. Wird der Halbleiterkörper vor dem Waferbonden beispielsweise auf eine Schichtdicke von ca. 205 *µ*m gedünnt, so ist ein Kontaktlochdurchmesser von ca. 30 *µ*m ausreichend. Dieser führt dann zu einem ausreichend niedrigen Aspektverhältnis, sodass bei der späteren Abscheidung der Metallisierung noch keine Probleme mit schlechter Bedeckung des Kontaktlochboden entstehen.

Im nächsten Schritt wird bei dieser Variante die Trennschicht am Kontaktlochboden durch Ätzen entfernt, z.B. mittels RIE. In einer anderen Variante kann die Trennschicht schon vor dem Waferbonden im Bereich der Kontaktlöcher entfernt sein. Anschließend wird das Kontaktloch an den Innenwänden elektrisch isoliert, wobei der Boden des Kontaktlochs frei bleibt. Dazu werden an den Innenwänden Spacer erzeugt, indem eine Hilfsschicht konform und isotrop innerhalb des Kontaktlochs abgeschieden und mit einem anisotropen Ätzverfahren so weit zurückgeätzt wird, bis die Hilfsschicht im Kontaktlochboden vollständig entfernt ist.

Für die Metallisierung wird vorzugsweise ein Metall verwendet, welches bei der verwendeten Technik der Halbleiterschaltung die oberste Metallschicht bildet. Möglich ist es jedoch auch, andere Metalle zu verwenden, die beispielsweise eine gute Konformität bei der Abscheidung auch bei hohen Grabentiefen bzw. hohen Aspektverhältnissen aufweisen. Angesichts des relativ hohen Kontaktlochdurchmessers ist es ausreichend, die Metallisierung nur bis zu einer gewünschten Schichtdicke abzuscheiden. Der verbleibende Innenraum kann anschließend mit einem Dielektrikum, beispielsweise einem Polymer und insbesondere mit Polyimid ausgefüllt werden. Möglich ist es jedoch auch, den Innenraum des Kontaktlochs freizulassen.

Nach Kontaktlochauffüllung wird gegebenenfalls überstehendes Material entfernt, indem die Oberfläche planarisiert wird. Anschließend wird die Metallisierung, die auch an der Oberfläche des Halbleiterkörper aufgebracht ist, so strukturiert, dass daraus gleichzeitig entsprechende Verschaltungsstrukturen wie Anschlussleitungen und Anschlusspads entstehen. Dies kann dadurch unterstützt werden, dass der letzte anisotrope Ätzschritt zum Herstellen von Öffnungen in der Isolatorschicht über dem Halbleiterkörper genutzt wird, um so tiefer liegende Metallisierungen freizulegen. Die aufzubringende Metallisierung kontaktiert dann diese tiefer liegende Metallisierung.

Auf die Oberfläche des Bauelements kann anschließend über der Halbleiterstruktur und der Metallisierung eine weitere Passivierungsschicht aufgebracht werden, in der dann Öffnungen zum Freilegen von Anschlusspads erzeugt werden.

Im Folgenden wird die Erfindung anhand von Ausführungsbeispielen und der dazugehörigen Figuren näher erläutert. Diese dienen allein der Veranschaulichung der Erfindung und sind nur schematisch und nicht maßstabsgetreu ausgeführt. Gleiche oder gleich wirkende Teile sind mit gleichen Bezugszeichen bezeichnet.
Figur 1 zeigt ein erstes Bauelement im schematischen Querschnitt,
Figur 2 zeigt eine zweite Ausführungsform des Bauelements im schematischen Querschnitt,
Figur 3 zeigt das Bauelement in einem dazu vertikalen Querschnitt durch den Schichtaufbau,
Figur 4 zeigt das Bauelement in der Draufsicht,
Figur 5 zeigt verschiedene Verfahrensstufen bei der Herstellung eines Schichtaufbaus,
Figur 6 zeigt einen alternativ hergestellten Schichtaufbau im schematischen Querschnitt,
Figur 7 zeigt das Bauelement nach dem Waferbonden,
Figur 8 zeigt das Bauelement nach dem Herstellen von Kontaktlöchern,
Figur 9 zeigt das Bauelement nach der Herstellung von Spacern,
Figur 10 zeigt das Bauelement nach dem Erzeugen und Strukturieren einer Metallisierung,
Figur 11 zeigt das fertige Bauelement im schematischen Querschnitt.

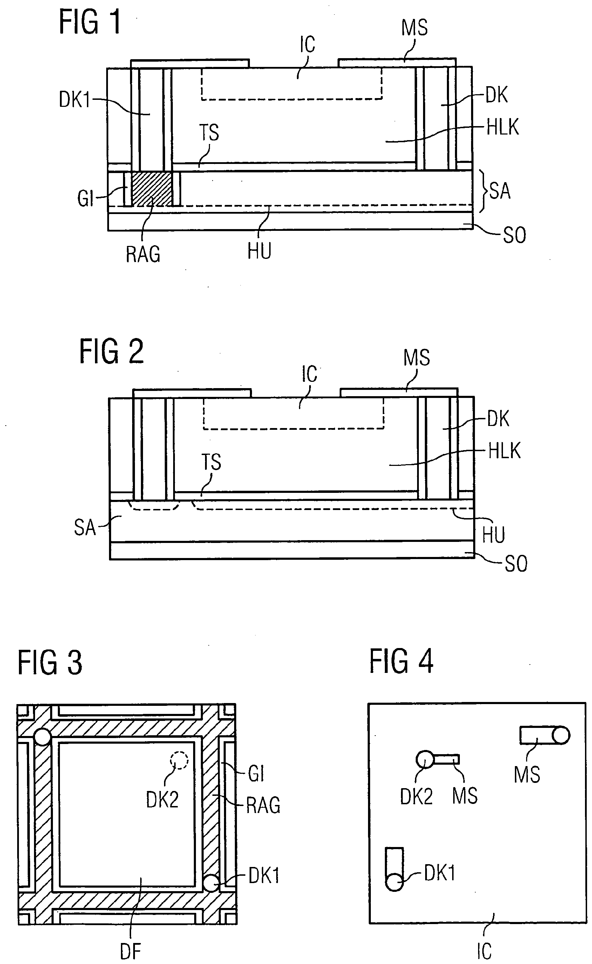

Figur 1 zeigt ganz schematisch ein erfindungsgemäßes Bauelement im schematischen Querschnitt. In einem Halbleiterkörper HLK ist eine integrierte Schaltung IC in der Nähe der Oberfläche des Halbleiterkörpers ausgebildet. Eine dielektrische Trennschicht TS trennt den Halbleiterkörper von einem Schichtaufbau SA, der n- und p- dotierte Teilschichten umfasst, die im Schichtaufbau SA einen Halbleiterübergang HU ausbilden. Nach unten ist das Bauelement mit einer isolierenden Schicht SO abgeschlossen.

Durch den Halbleiterkörper HLK sind Durchkontaktierungen DK geführt, die über eine Innenmetallisierung MS die Anschlüsse der integrierten Schaltung IC mit den funktionellen Schichten des Schichtaufbaus SA verbinden. Der Halbleiterübergang HU ist hier in der Nähe der Rückseite des Bauelements angeordnet und über ein dotiertes Rückseiten-Anschlussgebiet RAG mit der darüber angeordneten Durchkontaktierung verbunden. Das Rückseiten-Anschlussgebiet stellt eine niederohmige Verbindung durch den Schichtaufbau sicher und ist gegen diesen durch eine Grabenisolation GI isoliert.

Figur 2 zeigt eine zweite Ausführungsform des erfindungsgemäßen Bauelements, bei der der Halbleiterübergang HU in der Nähe der Oberfläche des Schichtaufbaus SA angeordnet und durch eine flächig begrenzte, flache Dotierung erzeugt ist. Die in der Figur rechts dargestellte Durchkontaktierung verbindet den durch die flache Dotierung gebildeten oberen Anschlusskontakt über eine Metallisierung MS mit entsprechenden Anschlüssen der Halbleiterschaltung IC. Die zweite in der Figur links dargestellte Durchkontaktierung DK kontaktiert einen an der Oberfläche des Schichtaufbaus neben der flache Dotierung gebildeten entgegengesetzt dotierten Bereich, die Rückseitenkontaktdotierung.

Figur 3 zeigt schematisch einen Querschnitt durch den Schichtaufbau parallel zu dessen Oberfläche. Das Rückseiten-Anschlussgebiet RAG, welches die unterste Teilschicht des Schichtaufbaus niederohmig mit der Oberseite des Schichtaufbaus verbindet, ist grabenförmig ausgebildet, wobei der Graben ringförmig geschlossen ist und die eigentliche Diodenfläche DF umschließt. Das Rückseiten-Anschlussgebiet RAG ist beiderseits von einer Grabenisolierung GI umgeben und so gegenüber dem restlichen Schichtaufbau isoliert. Mit einer gepunkteten Linie sind die Positionen der in dieser Schnittebene eigentlich nicht sichtbaren Durchkontaktierungen DK angedeutet. Zumindest eine Durchkontaktierung DK2 ist innerhalb der durch das Rückseiten-Anschlussgebiet umschlossenen Diodenfläche DF und eine weitere Durchkontaktierung DK2 im Bereich des Rückseiten-Anschlussgebiets RAG angeordnet. Möglich ist es auch, pro Bauelement mehr als zwei der genannten Durchkontaktierungen vorzusehen.

Figur 4 zeigt das Bauelement in der Draufsicht auf die Oberfläche des Halbleiterkörpers. Dort münden alle Durchkontaktierungen DK und sind über Metallisierungen MS, die in Form kurzer Leiterbahnabschnitte ausgebildet bzw. strukturiert sind, mit entsprechenden Anschlüssen der Halbleiterschaltung IC (in der Figur nicht dargestellt) verbunden.

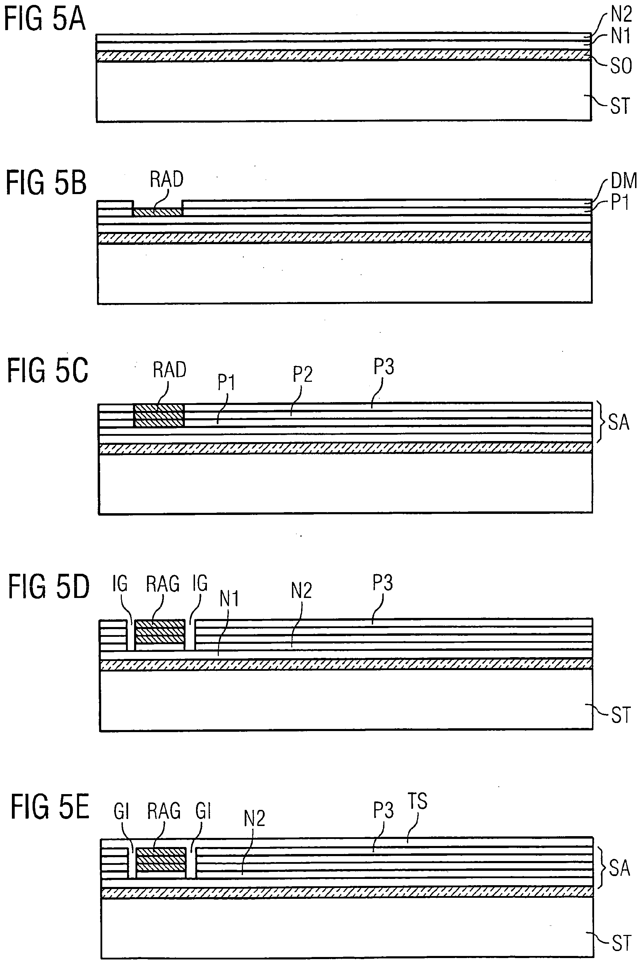

Figur 5 zeigt verschiedene Verfahrensstufen bei der Herstellung einer Fotodiode aus einem Schichtaufbau gemäß einer ersten Ausführungsvariante. Figur 5A zeigt als Ausgangspunkt ein SOI-Substrat, welches auf einem Hilfsträger ST angeordnet einen Isolator SO und darüber zwei Teilschichten aus einem Halbleiter aufweist, hier eine erste n⁺ -dotierte Teilschicht N1 und eine zweite n-dotierte Teilschicht N2. Die beiden Teilschichten können durch einen SOI-Prozess erzeugt sein.

Möglich ist es jedoch auch, von einem SOI-Substrat mit einer einzigen Teilschicht auszugehen und über diesem weitere Teilschichten vorzugsweise epitaktisch abzuscheiden. Die gewünschten Dotierungen können sowohl durch den SOI-Prozess als auch durch die epitaktische Abscheidung erzeugt werden.

Über den beiden n-dotierten Teilschichten N1, N2 wird nun eine erste p-dotierte Teilschicht P1 epitaktisch in einer Dicke von ca. 3 *µ*m erzeugt. In diese wird nun für den Rückseitenanschluss eine n-dotierte Zone - die Rückseitenanschlussdotierung RAD - mit Hilfe einer Dotiermaske DM eingebracht. Die Figur 5B zeigt die Anordnung auf dieser Verfahrensstufe.

Anschließend wird die Dotiermaske entfernt, eine weitere p-dotierte Teilschicht P2 in der gleichen Dicke aufgebracht und wieder im Bereich des Rückseitenanschlusses mit Hilfe einer weiteren Dotiermaske dotiert. Diese Schritte können sich mehrfach wiederholen, bis eine ausreichende Anzahl von p-dotierten Schichten entstanden ist, die zusammen einen Schichtaufbau der gewünschten Schichtdicke von beispielsweise 10 *µ*m ergeben. In der Figur sind dazu drei p-dotierten Teilschichten P1 bis P3 dargestellt. Die Rückseitenanschlussdotierung RAD kann später nach dem Füllen der Isoliergräben IG mit Isoliermaterial durch einen Temperschritt anschließend homogenisiert werden, sodass sich ein durchgehend homogen dotiertes Rückseiten-Anschlussgebiet RAG ergibt.

Im nächsten Schritt werden beiderseits des Rückseiten-Anschlussgebiets RAG Isoliergräben IG geätzt, beispielsweise in einem Aspektverhältnis von 1:5 bis 1:10. Figur 5D zeigt die Anordnung auf dieser Verfahrensstufe. Die Isoliergräben IG werden zumindest durch alle p-dotierten Schichten P1 bis P3 geführt und enden im Bereich der zweiten n-dotierten Teilschicht N2 oder über der ersten Teilschicht P1.

Im nächsten Schritt werden die Isoliergräben IG mit einem Isoliermaterial gefüllt. Dies kann durch uniforme bzw. isotrope Abscheidung von Isoliermaterial erfolgen. Dabei kann der Prozess noch thermisch unterstützt werden, wobei sowohl in den Grabenwänden als auch auf der Oberfläche des Schichtaufbaus ein thermisches Oxid aufwächst. Geeignete Abscheideverfahren sind dabei SACVD (Sub-Atmospheric CVD), PECVD (Plasma-Enhanced CVD) und HDP-Oxid (High-Density Plasma). Geeignet ist z.B. ein durch eine Ozon Atmosphäre unterstützter TEOS Prozess. Durch die Abscheidung des Isolationsmaterials, insbesondere eines Oxids, wird gleichzeitig die Oberfläche des Schichtaufbaus SA mit bedeckt und kann dort als Trenn schicht TS verbleiben. Gegebenenfalls erfolgt anschließend ein Abschleifen bzw. Planarisieren der Trennschicht. Figur 5E zeigt die Anordnung auf dieser Verfahrensstufe.

Nun kann der Schichtaufbau mit einem Halbleiterkörper mittels Waferbonden verbunden werden, z.B. durch Plasmaaktivierung und Backen bei einer Temperatur bis maximal 400°C. Vorher können die Wafer noch gedünnt werden.

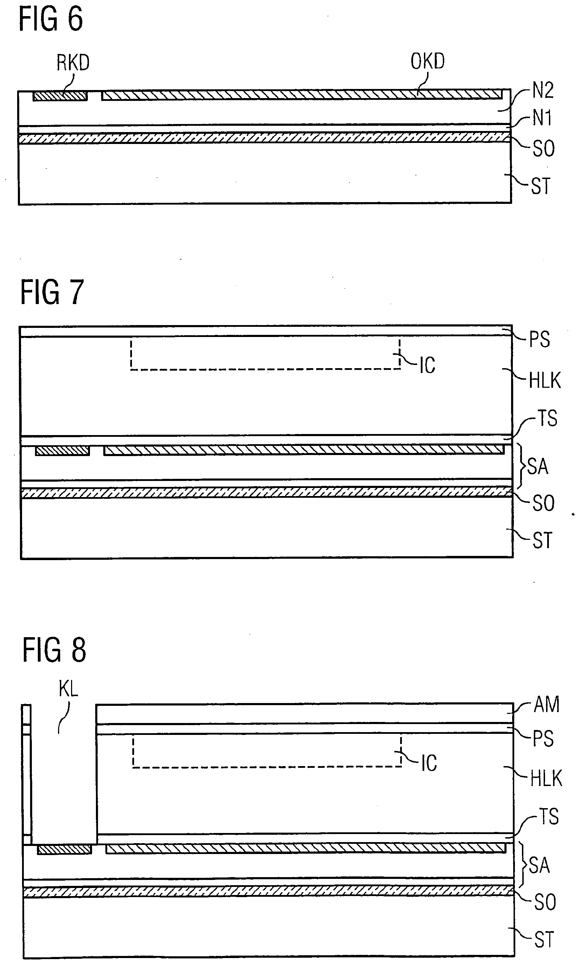

Figur 6 zeigt das Ergebnis einer zweite Verfahrensvariante, bei der von einem SOI-Substrat mit einer ersten n⁺-dotierten Teilschicht N1 und einer zweiten relativ dicken n-dotierten Teilschicht N2 ausgegangen wird. Die Teilschichten des SOI-Substrats weisen dabei zusammen die für den Schichtaufbau SA vorgesehene Gesamtschichtdicke auf.

In einem begrenzten Oberflächenbereich wird nun ein Oberflächenkontakt OKD durch Implantation einer p⁺ -Dotierung erzeugt. In einem davon verschiedenen Oberflächenbereich wird nun mittels n⁺ -Dotierung eine Rückseitenkontaktdotierung RKD erzeugt. Diese dient zum Anschluss der n-dotierten Teilschichten, sodass nun n- und p-dotierte Teilschichten auf der Oberfläche des Schichtaufbaus angeschlossen werden können. Über diesem in Figur 6 dargestellten Schichtaufbau wird nun eine Trennschicht TS erzeugt und gegebenenfalls planarisiert.

Alternativ kann die Rückseitenkontaktdotierung RKD vor oder nach dem Erzeugen der Trennschicht TS durch Isoliergräben ähnlich wie das bereits beschriebene Rückseitenanschlussgebiet RAG gegen den übrigen Schichtaufbau isoliert werden.

Die Planarisierung kann mittels chemisch-mechanischen Polierens (P) erfolgen, wobei eine Oberflächenrauhigkeit im Angstroem-Bereich erreicht wird wird. Anschließend wird das Ganze durch Waferbonden mit einem Halbleiterkörper HLK verbunden, in dessen nicht zum Bonden verwendete Oberfläche die Halbleiterschaltung IC ausgebildet und mit einer Passivierungsschicht PS abgedeckt ist. Figur 7 zeigt die Anordnung nach dem Waferbonden.

Im nächsten Schritt werden die Kontaktlöcher mittels eines DRIE-Prozesses anisotrop durch den Halbleiterkörper geätzt. Die Strukturierung erfolgt mittels einer Ätzmaske AM. Die als Ätzstopp dienende Trennschicht TS wird anschließend über einen weiteren RIE Ätzprozess entfernt, sodass die Oberfläche des Schichtaufbaus im so entstehenden Kontaktloch KL freigelegt wird. Zumindest ein Kontaktloch ist im Bereich der Rückseitenkontaktdotierung RKD ausgeführt, ein weiteres Kontaktloch (in der Figur nicht dargestellt) endet im Bereich der oberen Kontaktdotierung OKD. Figur 8 zeigt die Anordnung auf dieser Verfahrensstufe.

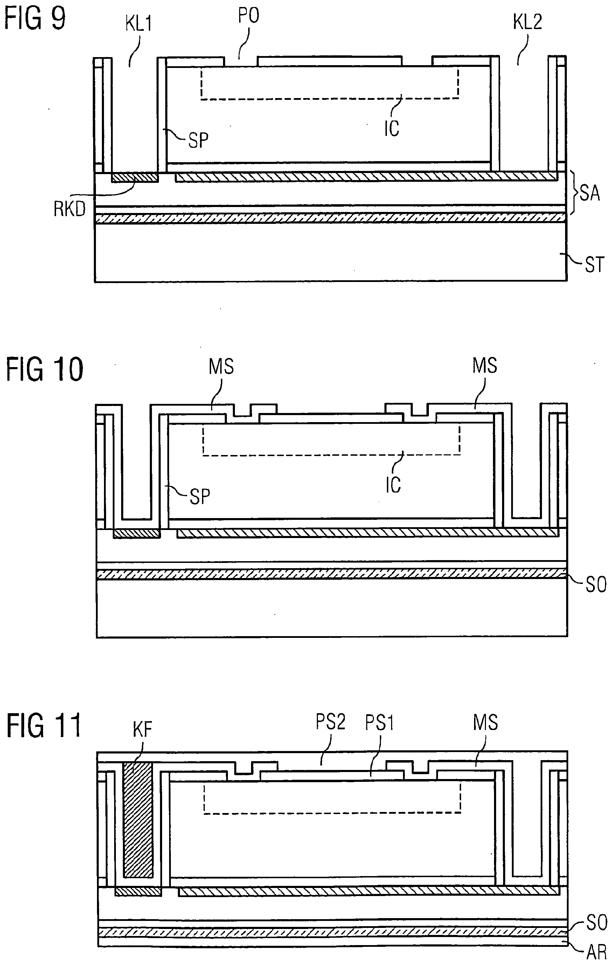

Die Innenisolierung der Kontaktlöcher kann beispielsweise mittels eines PECVD-Oxids vorgenommen werden, wobei eine Schichtdicke im Bereich von 1 *µ*m oder weniger ausreichend ist. Anschließend wird eine RIE Spacer-Ätzung durchgeführt, bei der die Oxidschicht am Boden des Kontaktlochs wieder entfernt wird, während an den Seitenwänden die isolierenden Spacer SP verbleiben. Vorteilhaft wird diese Spacer-Ätzung mit Hilfe einer weiteren Ätzmaske durchgeführt, um dabei gleichzeitig Öffnungen PO in der Passivierungsschicht PS zu erzeugen, in denen Anschlüsse der Halbleiterschaltung IC freigelegt werden. Figur 9 zeigt die Anordnung auf dieser Verfahrensstufe, wobei hier beide Typen von Kontaktlöchern zum Anschluss der n- und p-dotierten Teilschichten des Schichtaufbaus dargestellt sind.

Im nächsten Schritt wird ganzflächig eine Metallisierung MS erzeugt, die sowohl an der Oberfläche des Halbleiterkörpers als auch in den Kontaktlöchern sämtliche freiliegenden Oberflächen bedeckt. Anschließend wird die Metallisierung MS so strukturiert, dass auf der Oberfläche des Halbleiterkörpers entsprechende Anschlussleitungen hin zu den in den Öffnungen PO freigelegten Anschlüssen der Halbleiterschaltung IC herausgebildet werden. Gleichzeitig werden dabei die Metallisierungen zwischen den beiden Kontaktlöchern KL1 und KL2 elektrisch getrennt, ebenso Verbindungen zu weiteren Bauelementen, die gegebenenfalls im selben Substrat großflächig parallel miterzeugt wurden. Figur 10 zeigt die Anordnung auf dieser Verfahrensstufe.

Anschließend kann das Kontaktloch mit einer isolierenden Kontaktlochfüllung KF versehen werden und die übrige Oberfläche des Halbleiterkörpers mit einer zweiten Passivierungsschicht PS2 zum Schutz der CMOS-Strukturen versehen werden.

Im nächsten Schritt wird der Hilfsträger ST entfernt, wobei wahlweise ein Spin-Ätzverfahren eingesetzt werden kann. Dabei wird die Oberfläche des Isolators SO freigelegt, der anschließend wieder mit einer Passivierung und/oder einer Anti-reflexschicht AR versehen wird. Figur 11 zeigt die Anordnung auf dieser Verfahrensstufe. Zur Vervollständigung des Bauelements müssen nun nur noch die elektrischen Anschlüsse in Form von Öffnungen durch die zweite Passivierungsschicht PS2 erzeugt werden.

Obwohl in den Ausführungsbeispielen nur die Herstellung einer Fotodiode und einer Halbleiterschaltung und deren Verbindung zu einem Bauelement erläutert wurde, kann das Verfahren in einfacher Weise auch mit großflächigen SOI-Substraten und ebenso großflächigen Halbleiterkörpern (Wafern) durchgeführt werden. Dabei werden die Strukturierungsschritte so geführt, dass eine Vielzahl von elektrisch voneinander getrennten Elektroden und elektrisch voneinander getrennten Halbleiterschaltungen in einem regelmäßigen Muster nebeneinander erzeugt werden. Am Schluss des Verfahrens ist es möglich, die großflächigen Substrate und Halbleiterkörper wieder in einzelne Bauelemente aufzutrennen. Möglich ist es jedoch auch, auf diese Weise ein Diodenarray und insbesondere ein Fotodiodenarray herzustellen.

Die Erfindung ist auch nicht auf die dargestellten Ausführungsbeispiele beschränkt. Insbesondere zur Herstellung des Schichtaufbaus kann von unterschiedlichen SOI-Substraten ausgegangen werden. Die Dotierung von Teilschichten kann durch Abscheiden entsprechend dotierter CVD Schichten, vorzugsweise epitaktischer Schichten, durch Implantation oder integriert im SOI-Prozess erzeugt werden. Die beiden vorgestellten Verfahrensvarianten zur Herstellung des Schichtaufbaus erlauben eine beliebige Steigerung der Schichtdicke des Schichtaufbaus, ohne dass dadurch die Performance des Bauelements reduziert wird. Der Schichtaufbau für die Fotodiode ist auch nicht auf Siliziumschichten beschränkt. Möglich ist es auch, andere für Fotodioden übliche Materialien auf die gleiche Art und Weise zum Schichtaufbau zu kombinieren. Die Teilschichten können auch den Bandabstand regulierende Zusätze enthalten, beispielsweise Germanium oder Stickstoff. Auch kohlenstoffhaltige Siliziumschichten können als Teilschichten des Schichtaufbaus eingesetzt werden.

### Bezugszeichenliste

- IC: Halbleiterschaltung
- HLK: Halbleiterkörper
- TS: Trennschicht
- SA: Schichtaufbau
- SO: Isolator
- DK: Durchkontaktierung
- HU: Halbleiterübergang
- IG: Isolationsgraben
- GI: Grabenisolation
- DF: Diodenfläche
- ST: Hilfsträger
- N1, N2: Erste und zweite n-dotierte Teilschicht
- P1, P2: Erste und zweite p-dotierte Teilschicht
- DM: Dotiermaske
- RAD: Rückseitenanschlussdotierung
- PS: Passivierungsschicht
- AM: Ätzmaske
- KL: Kontaktloch
- SP: Spacer
- PO: Öffnung in PS
- MS: Metallisierung
- KF: Kontaktlochfüllung
- PS2: Zweite Passivierungsschicht
- AR: Antireflexschicht
- RAG: Rückseitenanschlussgebiet
- OKD: Oberflächenkontakt
- RKD: Rückseitenkontaktdotierung

## Patentansprüche

1. Elektrisches Bauelement
- mit einem kristallinen Halbleiterkörper (HLK),
- mit einer dielektrischen Trennschicht (TS) auf der Unterseite des Halbleiterkörpers,
- mit einem verschiedene Teilschichten umfassenden Schichtaufbau (SA) auf der von dem Halbleiterkörper abgewandten Seite der Trennschicht,
- mit einer Fotodiode, die in dem Schichtaufbau ausgebildet ist, und
- mit einer Halbleiterschaltung (IC), wobei eine von der Trennschicht abgewandte Rückseite des Schichtaufbaus als Lichteinfallsfläche zur Verfügung steht,
**dadurch gekennzeichnet, dass**
- die Halbleiterschaltung (IC) auf der der Unterseite gegenüberliegenden Oberseite des Halbleiterkörpers ausgebildet ist und
- Durchkontaktierungen (DK) durch den Halbleiterkörper, die die Fotodiode elektrisch mit der Halbleiterschaltung verbinden, vorhanden sind, wobei
- der Schichtaufbau (SA) zur Ausbildung eines Halbleiterübergangs der Fotodiode entweder einander entgegengesetzt dotierte und übereinander angeordnete Teilschichten (N1, N2, P1, P2, P3) aufweist, wobei die Durchkontaktierungen (DK) die oberste dieser Teilschichten (P3) direkt und die unterste dieser Teilschichten (N1) über ein ebenfalls dotiertes Rückseiten-Anschlussgebiet (RAG) kontaktieren, oder eine Rückseitenkontaktdotierung (RKD) und daneben eine zu der Rückseitenkontaktdotierung (RKD) entgegengesetzt dotierte Oberflächenkontaktdotierung (OKD) aufweist, wobei die Durchkontaktierungen (DK) die Rückseitenkontaktdotierung (RKD) und die Oberflächenkontaktdotierung (OKD) jeweils direkt kontaktieren.

2. Bauelement nach Anspruch 1,
bei dem der Schichtaufbau (SA) mit der darin angeordneten Fotodiode zumindest umfasst
- eine n⁺-dotierte Teilschicht als unterste Schicht,
- eine n-dotierte Teilschicht,
- eine p-dotierte Teilschicht und/oder eine p⁺-dotierte Anschlussdotierung und
- einen Halbleiterübergang.

3. Bauelement nach Anspruch 1 oder 2,
bei dem die Durchkontaktierungen (DK) als Löcher ausgebildet sind, die durch die Trennschicht (TS) bis zur obersten Schicht des Schichtaufbaus (SA) geführt und innen mit einer Metallisierung (MS) ausgekleidet sind.

4. Bauelement nach einem der Ansprüche 1 bis 3,
bei dem in der obersten Teilschicht des Schichtaufbaus (SA) über einer relativ dicken n-dotierten Teilschicht eine relativ dünne p⁺-dotierte obere Kontaktdotierung (OKD) und daneben eine n⁺-dotierte Rückseitenkontaktdotierung (RKD) vorgesehen sind.

5. Bauelement nach einem der Ansprüche 3 oder 4,
bei dem sich im Schichtaufbau (SA) ein n-dotiertes Rückseiten-Anschlussgebiet (RAG) von der untersten n⁺-dotierten Teilschicht durch alle darüber liegenden Teilschichten erstreckt und bei dem zumindest eine Durchkontaktierung (DK) bis zum Rückseiten-Anschlussgebiet geführt ist.

6. Bauelement nach Anspruch 4 oder 5,
bei dem der Anodenkontakt der Fotodiode über eine p⁺-dotierte obere Kontaktdotierung (OKD) erfolgt und bei dem zumindest eine Durchkontaktierung (DK) bis zu dieser p⁺-dotierten Kontaktdotierung geführt ist.

7. Bauelement nach einem der Ansprüche 5 oder 6,
bei dem das Rückseiten-Anschlussgebiet (RAG) sich am äußeren Rand der Fotodiode erstreckt und an seinen Seitenwänden mit einer Grabenisolierung (GI) gegen den übrigen Schichtaufbau (SA) isoliert ist.

8. Bauelement nach einem der Ansprüche 1 bis 7,
umfassend eine Vielzahl von regelmäßig angeordneten Fotodioden und Halbleiterschaltungen (IC), die jeweils miteinander verbunden sind.

9. Bauelement nach Anspruch 8,
bei dem die einzelnen Fotodioden durch mit einem isolierenden Material (GI) gefüllte Gräben (IG) gegeneinander isoliert sind.

10. Bauelement nach einem der Ansprüche 1 bis 9,
bei dem die Fotodiode aus zumindest zum Teil epitaktisch ausgebildeten Silizium-Teilschichten aufgebaut ist.

11. Verfahren zur Herstellung eines Bauelements nach dem Anspruch 1,
- bei dem in einem kristallinen Halbleiterkörper (HLK) eine Halbleiterschaltung (IC) erzeugt wird,
- bei dem auf einem SOI Substrat ein Schichtaufbau (SA) mit einem Halbleiterübergang und darin eine Fotodiode erzeugt wird, und der Schichtaufbau (SA) entweder
durch einander entgegengesetzt dotierte, übereinander angeordnete Teilschichten (N1, N2, P1, P2, P3) gebildet wird, wobei die Durchkontaktierungen (DK) direkt mit der obersten dieser Teilschichten (P3) und über ein ebenfalls dotiertes Rückseiten-Anschlussgebiet (RAG) mit der untersten dieser Teilschichten (N1) elektrisch leitend verbunden werden, oder
an der dem Halbleiterkörper (HLK) zugewandten Oberseite mit einer Rückseitenkontaktdotierung (RKD) und einer zu der Rückseitenkontaktdotierung (RKD) entgegengesetzt dotierten Oberflächenkontaktdotierung (OKD) versehen wird, wobei die Durchkontaktierungen (DK) direkt auf die Rückseitenkontaktdotierung (RKD) und auf die Oberflächenkontaktdotierung (OKD) aufgebracht werden,
- bei dem der Halbleiterkörper und das SOI Substrat mit dem Schichtaufbau mit einem Waferbondverfahren verbunden werden,
- bei dem von der Oberseite des Halbleiterkörpers bis zum Schichtaufbau reichende Kontaktlöcher (KL) durch Ätzen erzeugt und innen metallisiert werden, wobei Durchkontaktierungen (DK) entstehen,
- bei dem die im Schichtaufbau erzeugte Fotodiode mit der Halbleiterschaltung elektrisch verbunden wird.

12. Verfahren nach Anspruch 11,
- bei dem ein SOI Substrat eingesetzt wird, das über dem Isolator (SO) eine n⁺-dotierte Teilschicht und darüber eine n-dotierte Teilschicht aufweist,
- bei dem in der n-dotierten Teilschicht nebeneinander eine n⁺-dotierte Rückseitenkontaktdotierung (RKD) und eine p⁺-dotierte obere Kontaktdotierung (OKD) erzeugt werden,
- bei dem zumindest je eine Durchkontaktierung (DK) zur Rückseitenkontaktdotierung (RKD) und zur oberen Kontaktdotierung (OKD) geführt wird.

13. Verfahren nach Anspruch 11,
- bei dem im Schichtaufbau (SA) ein von der untersten Teilschicht zur obersten Teilschicht reichendes Rückseiten-Anschlussgebiet (RAG) mit einer Rückseitenanschlussdotierung (RAD) erzeugt und gegen den übrigen Schichtaufbau durch einen mit einem isolierenden Material (GI) gefüllten Graben (IG) isoliert wird,
- bei dem im Rückseiten-Anschlussgebiet (RAG) eine oberflächliche n⁺-Rückseitenkontaktdotierung (RKD) erzeugt wird und
- bei dem eine lochförmige Durchkontaktierung (DK) durch den Halbleiterkörper (HLK) zur Rückseitenkontaktdotierung geführt wird.

14. Verfahren nach einem der Ansprüche 11 bis 13,
bei dem der Halbleiterkörper (HLK) vor dem Waferbonden an der Rückseite gedünnt wird.

15. Verfahren nach einem der Ansprüche 11 bis 14,
bei dem vor dem Waferbonden auf zumindest eine Oberfläche ausgewählt aus Oberseite Schichtaufbau (SA) und Unterseite Halbleiterkörper (HLK) eine Trennschicht (TS) aufgebracht wird,
bei dem die Trennschicht nach dem Waferbonden während des Ätzens der Kontaktlöcher (KL) als Ätzstoppschicht verwendet wird.

16. Verfahren nach einem der Ansprüche 13 bis 15,
- bei dem ein SOI Substrat mit zumindest einer n⁺-dotierten Teilschicht verwendet wird,
- bei dem mehrere p-dotierte Teilschichten auf dem SOI Substrat durch Epitaxie erzeugt werden, wobei in jeder der Teilschichten nach dem Erzeugen im Rückseiten-Anschlussgebiet (RAG) eine n⁺-Rückseitenanschlussdotierung (RAD) erzeugt wird,
- bei dem in der obersten Teilschicht außerhalb des Rückseiten-Anschlussgebietes eine p⁺-dotierte obere Kontaktdotierung (OKD) erzeugt wird.

17. Verfahren nach einem der Ansprüche 11 bis 16,
bei dem die Kontaktlöcher (KL) durch anisotropes Ätzen des Halbleiterkörpers (HLK) erzeugt, an den Innenwänden mit einem Spacer (SP) versehen und anschließend an der gesamten Innenfläche metallisiert werden,
wobei die dazu eingesetzte Metallisierung (MS) ganzflächig isotrop abgeschieden und anschließend auf der Oberfläche des Halbleiterkörpers strukturiert wird, um elektrische Verbindungen zwischen den Durchkontaktierungen (DK) und Anschlüssen der Halbleiterschaltung (IC) zu erzeugen.

18. Verfahren nach einem der Ansprüche 11 bis 17,
bei dem die innen metallisierten Kontaktlöcher (KL) mit einem Dielektrikum (KF) gefüllt werden.

19. Verfahren nach einem der Ansprüche 11 bis 18,
bei dem ein SOI Substrat mit einer n⁺-dotierten und einer n-dotierten Teilschicht verwendet wird,
bei dem
- entweder die beiden Teilschichten den gesamten Schichtaufbau (SA) darstellen und eine Gesamtdicke bis zu 20 µm aufweisen
- oder über den beiden Teilschichten solange p-dotierte Teilschichten in einer Dicke bis maximal je 3,5 µm mittels CVD angeordnet oder epitaktisch aufgebracht werden, bis ein Schichtaufbau (SA) mit einer Gesamtdicke bis 20 µm erreicht ist.

## Claims

1. An electric component
- having a crystalline semiconductor body (HLK);
- having a dielectric separation layer (TS) on an underside of the semiconductor body,
- having a laminar structure (SA) on the side of the separation layer facing away from the semiconductor body and comprising different partial layers,
- having a photodiode formed in the laminar structure, and
- having a semiconductor circuit (IC), wherein a rear side of the laminar structure facing away from the separation layer is available as a light incidence layer,
**characterized in that**
- the semiconductor circuit (IC) is formed on the upper side of the semiconductor body opposite the underside, and
- feedthroughs (DK) through the semiconductor body are present which electrically connect the photodiode to the semiconductor circuit, wherein,
- for forming a semiconductor junction of the photodiode, the laminar structure (SA) either has partial layers (N1, N2, P1, P2, P3) which are doped oppositely to one another and disposed one above the other, wherein the feedthroughs (DK) contact the uppermost of these partial layers (P3) directly and the lowermost of these partial layers (N1) via a likewise doped rear side terminal region (RAG), or a rear side contact doping (RKD) and, next to it, a surface contact doping (OKD) which is oppositely doped with respect to the rear side contact doping (RKD), wherein the feedthroughs (DK) in each case contact the rear side contact doping (RKD) and the surface contact doping (OKD) directly.

2. The component according to claim 1,
wherein the laminar structure (SA) with the photodiode arranged therein comprises at least
- an n⁺ doped partial layer as a lowermost layer,
- an n doped partial layer,
- a p doped partial layer and/or a p⁺ doped terminal doping, and
- a semiconductor junction.

3. The component according to claim 1 or 2,
wherein the feedthroughs (DK) are formed as holes which are guided through the separation layer (TS) up to the uppermost layer of the laminar structure (SA) and are internally lined with a metallization (MS).

4. The component according to one of claims 1 to 3,
wherein in the uppermost partial layer of the laminar structure (SA), above a relatively thick n doped partial layer, a relatively thin p⁺ doped upper contact doping (OKD) and, next to it, an n⁺ doped rear side contact doping (RKD) are provided.

5. The component according to one of claims 3 or 4,
wherein, in the laminar structure (SA), an n doped rear side terminal region (RAG) extends from the lowermost n⁺ doped partial layer through all of the partial layers situated thereupon, and wherein at least one feedthrough (DK) is guided up to the rear side terminal region.

6. The component according to one of claims 4 or 5,
wherein the anode contact of the photodiode is realized via a p⁺ doped upper contact doping (OKD), and wherein at least one feedthrough (DK) is guided up to this p⁺ doped contact doping.

7. The component according to one of claims 5 or 6,
wherein the rear side terminal region (RAG) extends on the outer edge of the photodiode and is insulated relative to the remaining laminar structure (SA) by means of a trench insulation (GI) on its side walls.

8. The component according to one of claims 1 to 7, comprising a plurality of regularly arranged photodiodes and semiconductor circuits (IC) that are respectively connected to one another.

9. The component according to claim 8,
wherein the individual photodiodes are mutually insulated by means of trenches (IG) that are filled with an insulating material (GI).

10. The component according to one of claims 1 to 9,
wherein the photodiode is constituted of silicon partial layers that are at least partially formed epitaxially.

11. A method for manufacturing a component according to claim 1,
- wherein a semiconductor circuit (IC) is produced in a crystalline semiconductor body (HLK),
- wherein, on an SOI substrate, a laminar structure (SA) with a semiconductor junction is produced, and therein, a photodiode is produced, and the laminar structure (SA) is formed either by partial layers (N1, N2, P1, P2, P3) which are doped oppositely with respect to one another and disposed one above the other, wherein the feedthroughs (DK) are directly connected to the uppermost of these partial layers (P3) in an electrically conducting manner and, via a likewise doped rear side terminal region (RAG), are connected to the lowermost of these partial layers (N1) in an electrically conducting manner, or
is provided with a rear side contact doping (RKD) on the upper side facing the semiconductor body (HLK) and with a surface contact doping (OKD) which is oppositely doped with respect to the rear side contact doping (RKD),
wherein the feedthroughs (DK) are applied to the rear side contact doping (RKD) and the surface contact doping (OKD) directly,
- wherein the semiconductor body and the SOI substrate are connected to the laminar structure by means of a wafer bonding process,
- wherein contact holes (KL) reaching from the upper side of the semiconductor body up to the laminar structure are produced by etching and internally metallized, whereby feedthroughs (DK) are formed,
- wherein the photodiode produced in the laminar structure is electrically connected to the semiconductor circuit.

12. The method according to claim 11,
- wherein an SOI substrate is used that comprises an n⁺ doped partial layer above the insulator (SO) and an n doped partial layer thereupon,
- wherein in the n doped partial layer, an n⁺ doped rear side contact doping (RKD) and a p⁺ doped upper contact doping (OKD) are produced next to one another,
- wherein in each case at least one feedthrough (DK) is guided to the rear side contact doping (RKD) and to the upper contact doping (OKD).

13. The method according to claim 11,
- wherein in the laminar structure (SA), a rear side terminal region (RAG) having a rear side terminal doping (RAD) and reaching from the lowermost partial layer to the uppermost partial layer is produced and insulated relative to the remaining laminar structure by means of a trench (IG) filled with an insulating material (GI),
- wherein a superficial n⁺ rear side contact doping (RKD) is produced in the rear side terminal region (RAG), and
- wherein a hole-shaped feedthrough (DK) is guided through the semiconductor body (HLK) to the rear side contact doping.

14. The method according to one of claims 11 to 13,
wherein, prior to the wafer bonding process, the semiconductor body (HLK) is made thinner on the rear side.

15. The method according to one of claims 11 to 14,
wherein, prior to the wafer bonding process, a separation layer (TS) is applied to at least one surface that is selected from the upper side of the laminar structure (SA) and the underside of the semiconductor body (HLK),
- wherein the separation layer is used as an etching barrier layer during the etching of the contact holes (KL) after the wafer bonding process.

16. The method according to one of claims 13 to 15,
- wherein an SOI substrate with at least one n⁺ doped partial layer is used,
- wherein several p doped partial layers are produced on the SOI substrate by means of epitaxy, wherein in the rear side terminal region (RAG), an n⁺ doped rear side terminal doping (RAD) is produced after the production in each of the partial layers,
- wherein outside the rear side terminal region, a p⁺ doped upper contact doping (OKD) is produced in the uppermost partial layer.

17. The method according to one of claims 11 to 16,
wherein the contact holes (KL) are produced by anisotropically etching the semiconductor body (HLK), are provided with a spacer (SP) on the inner walls, and subsequently are metallized over the entire inner surface, wherein the metallization (MS) used for this purpose is isotropically deposited over the entire surface and subsequently structured on the surface of the semiconductor body in order to produce electric connections between the feedthroughs (DK) and the terminals of the semiconductor circuit (IC).

18. The method according to one of claims 11 to 17,
wherein the internally metallized contact holes (KL) are filled with a dielectric (KF).

19. The method according to one of claims 11 to 18,
wherein an SOI substrat with an n⁺ doped and an n doped partial layer is used,
wherein
- the two partial layers either represent the entire laminar structure (SA) and have an overall thickness of up to 20 µm,
- or p doped partial layers with a thickness of up to a maximum of 3.5 µm each are arranged by means of CVD or epitaxially applied above the two partial layers until a laminar structure (SA) having an overall thickness of up to 20 µm is obtained.

## Revendications

1. Composant électrique présentant
- un corps semiconducteur cristallin (HLK),
- une couche de séparation diélectrique (TS) sur la face inférieure du corps semiconducteur,
- une structure de couches (SA) comprenant diverses couches partielles sur la face détournée du corps semiconducteur de la couche de séparation,
- une photodiode qui est constituée dans la structure de couches, et
- un circuit à semiconducteur (IC), sachant qu'une face arrière détournée de la couche de séparation de la structure de couches est disponible comme face d'incidence de lumière,
**caractérisé en ce que**
- le circuit à semiconducteur (IC) est constitué sur la face supérieure du corps semiconducteur qui est opposée à la face inférieure et
- des interconnexions traversantes (DK) qui relient électriquement la photodiode au circuit à semiconducteur sont présentes à travers le corps semiconducteur, sachant que
- la structure de couches (SA), pour la constitution d'une jonction à semiconducteur de la photodiode, présente soit des couches partielles (N1, N2, P1, P2, P3) dopées de façon opposée les unes aux autres et disposées au-dessus les unes des autres, sachant que les interconnexions traversantes (DK) mettent en contact directement la plus haute de ces couches partielles (P3) et via une zone de connexion en face arrière (RAG) également dopée la plus basse de ces couches partielles (N1), soit un dopage de contact en face arrière (RKD) et à côté de celui-ci un dopage de contact de surface (OKD) dopé de façon opposée au dopage de contact en face arrière (RKD), sachant que les interconnexions traversantes (DK) mettent en contact le dopage de contact en face arrière (RKD) et le dopage de contact de surface (OKD) directement, respectivement.

2. Composant selon la revendication 1,
sachant que la structure de couches (SA) comprenant la photodiode disposée dans celle-ci comprend au moins
- une couche partielle à dopage n⁺ comme couche la plus basse,
- une couche partielle à dopage n,
- une couche partielle à dopage p et/ou un dopage de raccordement à dopage p⁺ et
- une jonction à semiconducteur.

3. Composant selon la revendication 1 ou 2,
sachant que les interconnexions traversantes (DK) sont constituées comme trous qui sont menés à travers la couche de séparation (TS) jusqu'à la couche la plus haute de la structure de couches (SA) et sont revêtus intérieurement d'une métallisation (MS).

4. Composant selon l'une des revendications 1 à 3,
sachant qu'un dopage de contact haut (OKD) à dopage p⁺ relativement fin et à côté de celui-ci un dopage de contact en face arrière (RKD) à dopage n⁺ sont prévus dans la couche partielle la plus haute de la structure de couches (SA) au-dessus d'une couche partielle à dopage n relativement épaisse.

5. Composant selon l'une des revendications 3 ou 4,
sachant que, dans la structure de couches (SA), une zone de connexion en face arrière (RAG) à dopage n s'étend depuis la couche partielle à dopage n⁺ la plus basse à travers toutes les couches partielles situées au-dessus de celle-ci et sachant qu'au moins une interconnexion traversante (DK) est menée jusqu'à la zone de connexion en face arrière.

6. Composant selon la revendication 4 ou 5,
sachant que le contact anodique de la photodiode s'effectue via un dopage de contact haut (OKD) à dopage p⁺ et sachant qu'au moins une interconnexion traversante (DK) est menée jusqu'à ce dopage de contact à dopage p⁺.

7. Composant selon l'une des revendications 5 ou 6,
sachant que la zone de connexion en face arrière (RAG) s'étend au bord extérieur de la photodiode et est isolée au niveau de ses parois latérales par une isolation par sillons (GI) par rapport au reste de la structure de couches (SA).

8. Composant selon l'une des revendications 1 à 7,
comprenant une pluralité de photodiodes et de circuits à semiconducteur (IC) disposés régulièrement qui sont respectivement reliés les uns aux autres.

9. Composant selon la revendication 8,
sachant que les différentes photodiodes sont isolées les unes par rapport aux autres par des sillons (IG) remplis d'un matériau isolant (GI).

10. Composant selon l'une des revendications 1 à 9,
sachant que la photodiode est structurée à partir de couches partielles de silicium constituées au moins en partie de façon épitaxiale.

11. Procédé de fabrication d'un composant selon la revendication 1,
- dans lequel un circuit à semiconducteur (IC) est produit dans un corps semiconducteur cristallin (HLK),
- dans lequel une structure de couches (SA) avec une jonction à semiconducteur et dans celle-ci une photodiode est produite sur un substrat SOI, et la structure de couches (SA) est
soit formée par des couches partielles (N1, N2, P1, P2, P3) dopées de façon opposée les unes aux autres et disposées au-dessus les unes des autres, sachant que les interconnexions traversantes (DK) sont reliées de façon électriquement conductrice directement avec la plus haute de ces couches partielles (P3) et via une zone de connexion en face arrière (RAG) également dopée avec la plus basse de ces couches partielles (N1),
soit pourvue, sur la face supérieure tournée vers le corps semiconducteur (HLK), d'un dopage de contact en face arrière (RKD) et d'un dopage de contact de surface (OKD) dopé de façon opposée au dopage de contact en face arrière (RKD), sachant que les interconnexions traversantes (DK) sont appliquées directement sur le dopage de contact en face arrière (RKD) et sur le dopage de contact de surface (OKD),
- dans lequel le corps semiconducteur et le substrat SOI sont reliés avec la structure de couches par un procédé de liaison de plaquette,
- dans lequel des trous de contact (KL) allant de la face supérieure du corps semiconducteur à la structure de couches sont produits par gravure et métallisés intérieurement, sachant que des interconnexions traversantes (DK) sont créées,
- dans lequel la photodiode produite dans la structure de couches est reliée électriquement au circuit à semiconducteur.

12. Procédé selon la revendication 11,
- dans lequel on utilise un substrat SOI qui présente une couche partielle à dopage n⁺ au-dessus de l'isolant (SO) et une couche partielle à dopage n au-dessus de celle-ci,
- dans lequel, dans la couche partielle à dopage n, un dopage de contact en face arrière (RKD) à dopage n⁺ et un dopage de contact haut (OKD) à dopage p⁺ sont produits l'un à côté de l'autre,
- dans lequel au moins respectivement une interconnexion traversante (DK) est menée au dopage de contact en face arrière (RKD) et au dopage de contact haut (OKD).

13. Procédé selon la revendication 11,
- dans lequel, dans la structure de couches (SA), une zone de connexion en face arrière (RAG) allant de la couche partielle la plus basse à la couche partielle la plus haute est produite avec un dopage de connexion en face arrière (RAD) et est isolée par rapport au reste de la structure de couches par un sillon (IG) rempli d'un matériau isolant (GI),
- dans lequel un dopage de contact en face arrière (RKD) n⁺ superficiel est produit dans la zone de connexion en face arrière (RAG) et
- dans lequel une interconnexion traversante (DK) en forme de trou est menée au dopage de contact en face arrière à travers le corps semiconducteur (HLK).

14. Procédé selon l'une des revendications 11 à 13,
dans lequel le corps semiconducteur (HLK) est aminci au niveau de la face arrière avant la liaison de plaquette.

15. Procédé selon l'une des revendications 11 à 14,
dans lequel, avant la liaison de plaquette, une couche de séparation (TS) est apposée sur au moins une surface choisie parmi la face supérieure de la structure de couches (SA) et la face inférieure du corps semiconducteur (HLK),
sachant que la couche de séparation est utilisée comme couche d'arrêt de gravure pendant la gravure des trous de contact (KL) après la liaison de plaquette.

16. Procédé selon l'une des revendications 13 à 15,
- dans lequel un substrat SOI avec au moins une couche partielle à dopage n⁺ est utilisé,
- dans lequel plusieurs couches partielles à dopage p sont produites par épitaxie sur le substrat SOI, sachant qu'un dopage de connexion en face arrière (RAD) n⁺ est produit dans chacune des couches partielles après la production dans la zone de connexion en face arrière (RAG),
- dans lequel un dopage de contact haut (OKD) à dopage p⁺ est produit dans la couche partielle la plus haute en-dehors de la zone de connexion en face arrière.

17. Procédé selon l'une des revendications 11 à 16,
dans lequel les trous de contact (KL) sont produits par gravure anisotrope du corps semiconducteur (HLK), pourvus d'une entretoise (SP) au niveau des parois intérieures puis métallisés sur toute la face intérieure,
sachant que la métallisation (MS) employée à cet effet est déposée de façon isotrope sur toute la surface puis structurée sur la surface du corps semiconducteur pour produire des liaisons électriques entre les interconnexions traversantes (DK) et des connexions du circuit à semiconducteur (IC).

18. Procédé selon l'une des revendications 11 à 17,
dans lequel les trous de contact (KL) métallisés intérieurement sont remplis d'un diélectrique (KF).

19. Procédé selon l'une des revendications 11 à 18,
dans lequel un substrat SOI comprenant une couche partielle à dopage n⁺ ou une couche partielle à dopage n est utilisé, sachant que
- soit les deux couches partielles constituent toute la structure de couches (SA) et présentent une épaisseur de totale jusqu'à 20 µm,
- soit des couches partielles à dopage p d'une épaisseur allant jusqu'à 3,5 µm maximum sont disposées par CVD ou apposées épitaxialement au-dessus des deux couches partielles jusqu'à ce qu'une structure de couches (SA) d'une épaisseur totale jusqu'à 20 µm soit atteinte.
